# EUROPÄISCHE PATENTANMELDUNG

(11) **EP 3 896 726 A1**
(43) Veröffentlichungstag der Anmeldung: **20.10.2021**
(21) Anmeldenummer: 20170116.6
(22) Anmeldetag: 17.04.2020
(51) Int. Cl.: H01L 23/049, H02M 7/00, H05K 3/36, H01L 23/24

(54) **HALBLEITERMODUL MIT EINEM GEHÄUSE**

(71) Anmelder: Siemens Aktiengesellschaft, 80333 München (DE)
(72) Erfinder: Nährig, Matthias, 91315 Höchstadt an der Aisch (DE); Schmenger, Jens, 91301 Forchheim (DE)

(57) **Zusammenfassung**

Die Erfindung betrifft ein Halbleitermodul (2) mit einem Gehäuse (4), mindestens einem Halbleiterbauelement (10), einem ersten Substrat (18) und einem zweiten Substrat (30). Um ein Halbleitermodul (2) anzugeben, welches, im Vergleich zum Stand der Technik, kompakter ist, wird vorgeschlagen, dass zumindest das Halbleiterbauelement (10) und das erste Substrat (18) in dem Gehäuse (4) angeordnet sind, wobei das Halbleiterbauelement (10) elektrisch leitend mit mindestens einem Pin (14) verbunden ist, wobei der mindestens eine Pin (14) mit dem zweiten Substrat (18) kontaktiert und innerhalb des Gehäuses (4) unlösbar verbunden ist, wobei das erste Substrat (18) über den mindestens einen Pin (14) kraftschlüssig im Gehäuse (4) verbunden ist.

## Beschreibung

Die Erfindung betrifft ein Halbleitermodul mit einem Gehäuse, mindestens einem Halbleiterbauelement, einem ersten Substrat und einem zweiten Substrat.

Ferner betrifft die Erfindung einen Umrichter mit mindestens einem derartigen Halbleitermodul.

Darüber hinaus betrifft die Erfindung ein Verfahren zu Herstellung eines derartigen Halbleitermoduls, wobei das erste Substrat mit dem Pin verbunden wird und daraufhin das zweite Substrat mit demselben Pin verbunden wird.

Halbleitermodule, insbesondere Leistungsmodule, umfassen in der Regel Halbleiterbauelemente, insbesondere Leistungshalbleiter, beispielsweise IGBTs (Insulated-Gate Bipolar Transistoren), welche in einem Gehäuse aufgenommen und mit einem Keramiksubstrat verbunden sind. Das Halbleitermodul umfasst ferner zumindest zwei weitere Substrate, beispielsweise eine Hauptplatine mit einem Interface und eine Treiberplatine, welche mit dem Keramiksubstrat kontaktiert sind. Zur Kontaktierung werden separate Kontakte, Pins genannt, verwendet, die im Gehäuse oder auf dem Keramiksubstrat befestigt sind. Diese Kontakte benötigen Bauraum, wodurch die Größe des Leistungsmoduls beeinflusst wird.

Die Patentschrift DE 10 2017 207 382 B4 beschreibt eine Halbleitervorrichtung aufweisend eine Leistungsvorrichtung, einen Sensor, welcher einen physikalischen Zustand der Leistungsvorrichtung misst, um ein Signal gemäß dem physikalischen Zustand zu übertragen, einen Hauptelektrodenanschluss, durch welchen ein Hauptstrom der Leistungsvorrichtung fließt, einen Sensorsignalanschluss, der mit dem Sensor verbunden ist, um ein Signal von dem Sensor zu empfangen, einen Treiberanschluss, welcher eine Treiberleistung empfängt, um die Leistungsvorrichtung zu treiben und ein Gehäuse mit offener Unterseite, welches die Leistungsvorrichtung, den Sensor, den Hauptelektrodenanschluss, den Sensorsignalanschluss und den Treiberanschluss aufnimmt, wobei der Sensorsignalanschluss und der Treiberanschluss beide einen ersten Anschluss und einen zweiten Anschluss aufweisen, welche von einer inneren Seitenwandoberfläche des Gehäuses entfernt vorgesehen sind, wobei der erste und zweite Anschluss elektrisch miteinander verbunden sind, um eine Doppelstruktur zu bilden. Der erste Anschluss weist eine Länge auf, die ermöglicht, dass ein vorderes Endteil davon von einer oberen Oberfläche des Gehäuses außen vorsteht und das Signal und die Treiberleistung von/nach außen eingibt/ausgibt. Der zweite Anschluss weist eine Länge auf, die nicht zulässt, dass ein vorderes Endteil davon von der oberen Oberfläche des Gehäuses außen vorsteht.

Die Offenlegungsschrift EP 2 086 064 A1 beschreibt einen elektrischen Einpresskontakt, insbesondere einen Einpressstiftkontakt, zur Übertragung von elektrischem Strom und/oder elektrischen Signalen, mit einem Einpressabschnitt und einem Montageabschnitt, die über einen Entlastungsabschnitt miteinander mechanisch gekoppelt sind. Der Entlastungsabschnitt weist einen Ausgleichsbereich und einen Anschlagbereich auf, wobei der Ausgleichsbereich eine gekoppelte Relativbewegung des Einpressabschnitts und des Montageabschnitts zulässt, und der Anschlagbereich eine Aufeinanderzubewegung von Einpressabschnitt und Montageabschnitt blockiert.

Der Erfindung liegt die Aufgabe zugrunde, ein Halbleitermodul anzugeben, welches, im Vergleich zum Stand der Technik, kompakter ist.

Die Aufgabe wird erfindungsgemäß gelöst durch ein Halbleitermodul mit einem Gehäuse, mindestens einem Halbleiterbauelement, einem ersten Substrat und einem zweiten Substrat, wobei zumindest das Halbleiterbauelement und das erste Substrat in dem Gehäuse angeordnet sind, wobei das Halbleiterbauelement elektrisch leitend mit mindestens einem Pin verbunden ist, wobei der mindestens eine Pin mit dem zweiten Substrat kontaktiert und innerhalb des Gehäuses unlösbar verbunden ist, wobei das erste Substrat über den mindestens einen Pin kraftschlüssig im Gehäuse verbunden ist.

Ferner wird die Aufgabe erfindungsgemäß durch einen Umrichter mit mindestens einem derartigen Halbleitermodul gelöst.

Darüber hinaus wird die Aufgabe erfindungsgemäß durch ein Verfahren zu Herstellung eines derartigen Halbleitermoduls gelöst, wobei das erste Substrat mit dem Pin verbunden wird und daraufhin das zweite Substrat mit demselben Pin verbunden wird.

Die in Bezug auf das Halbleitermodul nachstehend angeführten Vorteile und bevorzugten Ausgestaltungen lassen sich sinngemäß auf den Umrichter und das Herstellungsverfahren übertragen.

Der Erfindung liegt die Überlegung zugrunde, in einem Halbleitermodul, welches ein Gehäuse aufweist und in welchem ein erstes Substrat und ein zweites Substrat zu kontaktieren sind, Bauraum einzusparen, indem mindestens ein Pin dazu verwendet wird ein zweites Substrat elektrisch leitend zu kontaktieren und, in einer zusätzlichen Funktion, ein erstes Substrat über den mindestens einen Pin kraftschlüssig im Gehäuse zu verbinden. Unter einer kraftschlüssigen Verbindung über den mindestens einen Pin des ersten Substrats im Gehäuse ist zu verstehen, dass das erste Substrat über mindestens einen Pin mit dem Gehäuse oder mit mindestens einer weiteren Komponente, welche mit dem Gehäuse in einer, insbesondere mechanischen, Verbindung steht, kraftschlüssig verbunden ist. Der Pin stellt eine elektrisch leitende Verbindung mit dem Halbleiterbauelement her und ist innerhalb des Gehäuses unlösbar verbunden. Eine unlösbare Verbindung wird beispielsweise durch Vergießen, Löten oder Sintern hergestellt. Aufgrund der unlösbaren Verbindung des Pins im Gehäuse wird das erste Substrat über den Pin im Gehäuse kraftschlüssig verbunden. Die kraftschlüssige Verbindung wird beispielsweise durch Verklemmen hergestellt. Durch eine derartige Anordnung werden Verbindungsmittel, beispielsweise Schrauben und/oder weitere Pins, sowie Bauraum eingespart. Das erste und das zweite Substrat sind beispielsweise aus einem glasfaserverstärkten Epoxidharz, insbesondere FR4, hergestellt und weisen beispielsweise eine beidseitige zumindest teilweise strukturierte Metallisierung, insbesondere eine Oberflächenmetallisierung, auf. Zumindest das erste Substrat ist zusammen mit dem Halbleiterbauelement in dem Gehäuse angeordnet, was zusätzlich Bauraum einspart. Bei der Montage wird zunächst das erste Substrat über den Pin kraftschlüssig verbunden, woraufhin das zweite Substrat mit demselben Pin verbunden wird. Ein derartiges Herstellungsverfahren ist leicht und kostengünstig zu realisieren.

Besonders vorteilhaft weist der Pin in einem ersten Kontaktbereich mit dem ersten Substrat ein Übermaß mit einem elastisch und/oder plastisch nachgebenden Bereich zur Herstellung der kraftschlüssigen Verbindung auf. Ein Übermaß ist beispielsweise eine Verdickung, insbesondere eine Stanzung. Ist der Bereich vorwiegend elastisch nachgebend ausgeführt, ist die kraftschlüssige Verbindung reversibel. Durch einen derartig ausgestalteten ersten Kontaktbereich ist das Substrat einfach im Gehäuse verbindbar.

Bei einer weiteren Ausgestaltung weist das erste Substrat eine erste Ausnehmung auf, die den Pin zumindest teilweise umschließt. Die Ausnehmung ist als geschlossene Ausnehmung, die den Pin vollständig umschließt, oder als offene beziehungsweise geöffnete Ausnehmung, die den Pin teilweise umschließt, ausgeführt. Eine Kontur der Ausnehmung ist abgerundet oder weist zumindest eine Ecke auf. Durch eine derartige Ausnehmung wird zusätzlich zur kraftschlüssigen Verbindung ein Formschluss erreicht, was zu einer mechanisch stabileren Verbindung führt.

Besonders vorteilhaft weist das erste Substrat zumindest im Bereich der ersten Ausnehmung eine metallische Beschichtung auf, sodass das erste Substrat elektrisch leitend mit dem Halbleiterbauelement verbunden ist. Insbesondere im Vergleich zum Löten ist bei einer derartigen Verbindung kein zusätzlicher Arbeitsschritt erforderlich.

Eine weitere Ausführungsform sieht vor, dass die metallisch beschichtete erste Ausnehmung als offene Ausnehmung ausgeführt ist, die den Pin im ersten Kontaktbereich teilweise, insbesondere maximal zur Hälfte, umschließt. Eine derartige Ausnehmung ist insbesondere am Rand des ersten Substrats oder am Rand einer Aussparung des ersten Substrats angeordnet, wo beispielsweise keine zu bestückenden Komponenten, insbesondere SMD-Komponenten, angeordnet sind, sodass kein zusätzlicher Platz für die erste Ausnehmung erforderlich ist. Eine derartige offene Ausnehmung ist daher platzsparend.

Bei einer weiteren Ausgestaltung ist die metallisch beschichtete erste Ausnehmung als Bohrungssegment ausgeführt. Derartige Bohrungssegmente sind einfach und kostengünstig herstellbar.

Eine weitere Ausführungsform sieht vor, dass der Pin derartig in der metallisch beschichteten ersten Ausnehmung angeordnet ist, dass eine im Wesentlichen linienförmige Pressungsverteilung ausgebildet ist. Eine derartige Pressungsverteilung ist für die kraftschlüssige Verbindung, insbesondere Klemmung, des ersten Substrats ausreichend und ist einfach und kostengünstig herstellbar.

Bei einer weiteren Ausgestaltung weist das zweite Substrat eine metallisch beschichtete zweite Ausnehmung auf, über welche der Pin kraftschlüssig und/oder stoffschlüssig mit dem zweiten Substrat elektrisch leitend verbunden ist. Eine kraftschlüssige Verbindung ist beispielsweise durch Einpressen und eine stoffschlüssige Verbindung ist beispielsweise durch Löten herstellbar. Erfahrungsgemäß haben sich derartige Verbindungen als vorteilhaft erwiesen.

Eine weitere Ausführungsform sieht vor, dass ein Durchmesser der zweiten Ausnehmung kleiner als ein Durchmesser der ersten Ausnehmung ist. Beispielsweise wird bei einer Fertigung des Halbleitermoduls zuerst das erste Substrat mit der größeren ersten Ausnehmung über den zweiten Kontaktbereich des Pins bewegt, ohne diesen zu berühren und wird im Bereich des ersten Kontaktbereichs kraftschlüssig verbunden. Daraufhin wird das zweite Substrat mit der kleineren zweiten Ausnehmung im zweiten Kontaktbereich desselben Pins verbunden. Durch die unterschiedlichen Durchmesser sind zwei Substrate einfach und kostengünstig mit demselben Pin verbindbar.

Bei einer weiteren Ausgestaltung ist das zweite Substrat über den mindestens einen Pin elektrisch leitend mit dem Halbleiterbauelement verbunden ist. Auf diese Weise ist das Halbleiterbauelement platzsparend mit zwei Substraten verbindbar.

Eine weitere Ausführungsform sieht vor, dass der Pin als freistehender Pin ausgeführt ist und einen elastischen Abschnitt aufweist. Ein derartiger freistehender Pin ist außerhalb des Gehäuses, welches beispielsweise ein Keramiksubstrat umschließt, angeordnet und frei auf dem Keramiksubstrat positionierbar. Der elastische Abschnitt gleicht thermische Belastungen, insbesondere thermische Längendehnungen, aus und trägt so zur mechanischen Stabilität bei.

Bei einer weiteren Ausgestaltung ist der Pin zumindest teilweise im Gehäuse verlaufend angeordnet. Beispielsweise ist der Pin zumindest teilweise in das Gehäuse eingegossen. Erfahrungsgemäß hat sich eine derartige Anordnung als vorteilhaft erwiesen.

Eine weitere Ausführungsform sieht vor, dass das Halbleitermodul einen Sensor umfasst, welcher zumindest einen Sensoranschluss aufweist, wobei das Halbleiterbauelement zumindest einen Treiberanschluss umfasst und wobei zumindest ein Sensoranschluss und zumindest ein Treiberanschluss über einen gemeinsamen Pin elektrisch leitend miteinander verbunden sind. Der Sensor ist beispielsweise als Temperatursensor ausgeführt, welcher thermisch mit dem Halbleiterbauelementverbunden ist. Beispielsweise sind ein Treiberanschluss, insbesondere ein Emitteranschluss, und ein Sensoranschluss mit einem gemeinsamen Bezugspotential, insbesondere mit einer negativen, Versorgungsspannung des Halbleiterbauelements verbunden. Alternativ wird ein gemeinsamer Pin über ein Frequenzmultiplexverfahren verwendet, wobei der Treiberanschluss in einem ersten Frequenzbereich und der Sensoranschluss in einem zweiten Frequenzbereich betrieben werden. Ein derartiger gemeinsamer Pin spart Bauraum im Halbleitermodul ein.

Im Folgenden wird die Erfindung anhand der in den Figuren dargestellten Ausführungsbeispiele näher beschrieben und erläutert.

Es zeigen:
- FIG 1: eine schematische Querschnittsdarstellung eines Ausschnitts einer ersten Ausgestaltung eines Halbleitermoduls,
- FIG 2: eine schematische Querschnittsdarstellung eines Ausschnitts einer zweiten Ausgestaltung eines Halbleitermoduls,
- FIG 3: eine vergrößerte Längsschnittdarstellung der ersten Ausgestaltung eines Halbleitermoduls im ersten Kontaktbereich,
- FIG 4: eine vergrößerte Querschnittsdarstellung der ersten Ausgestaltung eines Halbleitermoduls im ersten Kontaktbereich,
- FIG 5: eine schematische Querschnittsdarstellung eines Ausschnitts einer dritten Ausgestaltung eines Halbleitermoduls,
- FIG 6: eine schematische Querschnittsdarstellung eines Ausschnitts einer vierten Ausgestaltung eines Halbleitermoduls,
- FIG 7: eine schematische Darstellung eines Teils einer Schaltung des Halbleitermoduls und
- FIG 8: eine schematische Darstellung eines Umrichters mit einem Halbleitermodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

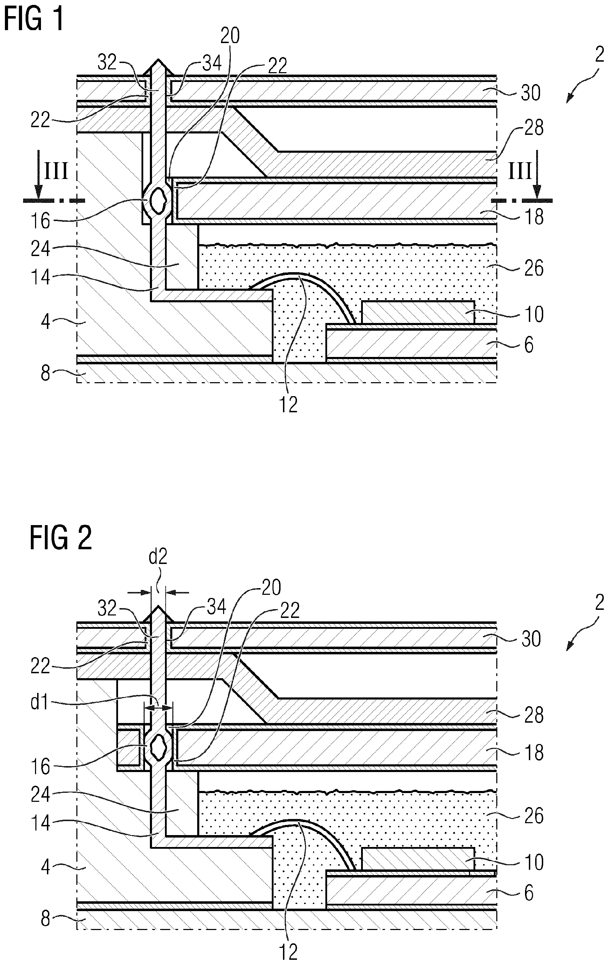

FIG 1 zeigt eine schematische Querschnittsdarstellung eines Ausschnitts einer ersten Ausgestaltung eines Halbleitermoduls 2, welches ein Gehäuse 4 aufweist, das aus einem Kunststoff gefertigt ist. Das Gehäuse 4 weist eine offene Unterseite auf und umschließt ein DCB-Keramiksubstrat 6, welches beispielsweise Aluminiumoxid und/oder Aluminiumnitrid enthält und eine beidseitige zumindest teilweise strukturierte Metallisierung, welche beispielsweise Kupfer enthält, aufweist. Das Gehäuse 4 und das DCB-Keramiksubstrat 6 liegen auf einer metallischen Bodenplatte 8 auf und sind mit dieser, insbesondere stoffschlüssig, verbunden. Die Bodenplatte 8 ist insbesondere als Kühlkörper, welcher beispielsweise Aluminium und/oder Kupfer enthält, ausgeführt, wobei die der Bodenplatte 8 zugewandte Metallisierung des DCB-Keramiksubstrats 6 elektrisch und thermisch leitend mit der Bodenplatte 8 verbunden ist. Auf der Bodenplatte 8 abgewandten Metallisierung des DCB-Keramiksubstrats 6 ist ein Halbleiterbauelement 10 stoffschlüssig mit der Metallisierung des DCB-Keramiksubstrats 6 verbunden. Das Halbleiterbauelement 10 ist über einen Bonddraht 12 elektrisch leitend mit einem Pin 14 verbunden, welcher in das Gehäuse 4 eingebettet ist. Der Pin 14 weist in einem ersten Kontaktbereich 16 ein Übermaß mit einem elastisch und/oder plastisch nachgebenden Bereich auf, wobei der erste Kontaktbereich 16 aus dem Gehäuse 4 hervorsteht. Der Pin 14 weist beispielsweise im ersten Kontaktbereich 16 einen Presspass-Anschluss auf. Ein erstes Substrat 18, welches beispielsweise zumindest eine Treiberschaltung, Signalverarbeitung und/oder eine Snubber-Schaltung umfasst, ist über den Pin 14 im Gehäuse durch Einklemmen kraftschlüssig verbunden, wobei der Pin 14 im ersten Kontaktbereich 16 elastisch und/oder plastisch verformt wird. Das erste Substrat 18 weist eine erste Ausnehmung 20 auf, in welche der Pin 14 teilweise aufgenommen ist. Darüber hinaus weist das erste Substrat 18 eine beidseitige zumindest teilweise strukturierte Metallisierung, insbesondere eine Oberflächenmetallisierung, auf und ist aus einem glasfaserverstärkten Epoxidharz, insbesondere FR4, hergestellt. Im Bereich der ersten Ausnehmung 20 weist das erste Substrat 18 eine vertikale Metallisierung 22 auf, welche mit der Oberflächenmetallisierung elektrisch leitend verbunden ist, sodass das erste Substrat 18 über den Pin 14 elektrisch leitend mit dem Halbleiterbauelement 12 verbunden ist. Insbesondere umschließt die metallisch beschichtete erste Ausnehmung 20 den Pin 14 im ersten Kontaktbereich 16 maximal zur Hälfte, wobei die erste Ausnehmung 20 beispielsweise als Bohrungssegment ausgeführt ist. Alternativ ist die erste Ausnehmung 20 gefräst ausgeführt und/oder weist mindestens eine Ecke auf. Auf mindestens einer gegenüberliegenden Seite des Halbleitermoduls 2, welches aus Gründen der Übersichtlichkeit nicht dargestellt ist, ist das erste Substrat 18 über mindestens einen weiteren Pin 14 oder über das Gehäuse 4 selbst zur Herstellung der kraftschlüssigen Verbindung kontaktiert.

Darüber hinaus weist das Gehäuse 4 im Wesentlichen unmittelbar unterhalb des ersten Kontaktbereichs 16 eine Auflagefläche 24 auf, sodass das erste Substrat 18 im Wesentlichen horizontal auf dem Gehäuse 4 aufliegt. Unterhalb der Auflagefläche 24 umfasst das Halbleitermodul 2 eine Vergussmasse 26, welche das Halbleiterbauelement 10 und den Bonddraht 12 umschließt. Ein Deckel 28, welcher beispielsweise aus einem Kunststoff hergestellt ist, ist auf dem ersten Substrat 18 angeordnet, wobei das erste Substrat 18 optional durch den Deckel 28 auf das Gehäuse 4 gepresst wird. Der Pin 14 verläuft außerhalb des Gehäuses 4 durch den Deckel 28 und ein zweites Substrat 30, wobei das zweite Substrat 30 eine beidseitige zumindest teilweise strukturierte Metallisierung, insbesondere Oberflächenmetallisierung, aufweist und aus einem glasfaserverstärkten Epoxidharz, insbesondere FR4, hergestellt ist. Der Pin 14 ist in einem zweiten Kontaktbereich 32 in einer, insbesondere zylinderförmigen, zweiten Ausnehmung 34 aufgenommen, welche den Pin 14 vollständig umgibt. Im Bereich der zweiten Ausnehmung 34 weist das zweite Substrat 30 eine vertikale Metallisierung 22 auf, welche mit der Oberflächenmetallisierung elektrisch leitend verbunden ist. Insbesondere bedeckt die vertikale Metallisierung 22 die zylinderförmige erste Ausnehmung 20 vollständig. Alternativ weist die Ausnehmung 20 eine eckige oder andersartige Form auf.

Der Pin 14 ist exemplarisch stoffschlüssig über eine Lötverbindung, mit der Metallisierung des zweiten Substrats 30 elektrisch und mechanisch verbunden, sodass das zweite Substrat 30 über den Pin 14 elektrisch leitend mit dem Halbleiterbauelement 10 verbunden ist. Das zweite Substrat 30, welches beispielsweise ein Interface und/oder eine Regelung aufweist, ist über die Verbindung mit dem Pin 14 im Halbleitermodul 2 fixiert. Optional ist das zweite Substrat 30 über weitere Befestigungsmittel, beispielsweise Schrauben, welche aus Gründen der Übersichtlichkeit nicht dargestellt sind, mit dem Gehäuse 4 verbunden.

FIG 2 zeigt eine schematische Querschnittsdarstellung eines Ausschnitts einer zweiten Ausgestaltung eines Halbleitermoduls 2. Das erste Substrat 18 weist eine beidseitige zumindest teilweise strukturierte Metallisierung, insbesondere eine Oberflächenmetallisierung, sowie eine, insbesondere zylinderförmige, erste Ausnehmung 20 auf, welche den Pin 14 in einem ersten Kontaktbereich 16 vollständig umgibt. Im Bereich der ersten Ausnehmung 20 weist das erste Substrat 18 eine vertikale Metallisierung 22 auf, welche mit der Oberflächenmetallisierung elektrisch leitend verbunden ist. Insbesondere bedeckt die vertikale Metallisierung 22 die zylinderförmige erste Ausnehmung 20 vollständig. Der Pin 14 weist im ersten Kontaktbereich 16 ein Übermaß mit einem elastisch und/oder plastisch nachgebenden Bereich auf, welcher beispielhaft als Presspass-Anschluss ausgeführt ist. Durch das Einpressen des ersten Substrats 18 wird der Pin 14 im ersten Kontaktbereich 16 elastisch und/oder plastisch verformt.

Ein erster Durchmesser dl der ersten Ausnehmung 20 ist größer als ein zweiter Durchmesser d2 der zweiten Ausnehmung 34, sodass bei einer Fertigung des Halbleitermoduls 2 zuerst das erste Substrat 18 mit der ersten Ausnehmung 20 über den zweiten Kontaktbereich 32 des Pins 14 bewegt und im Bereich des ersten Kontaktbereichs 16 kraftschlüssig verbunden wird. Daraufhin wird der Deckel 28 aufgesteckt und das zweite Substrat 30 mit dem Pin 14 verbunden. Die weitere Ausführung des Halbleitermoduls 2 in FIG 2 entspricht der Ausführung in FIG 1.

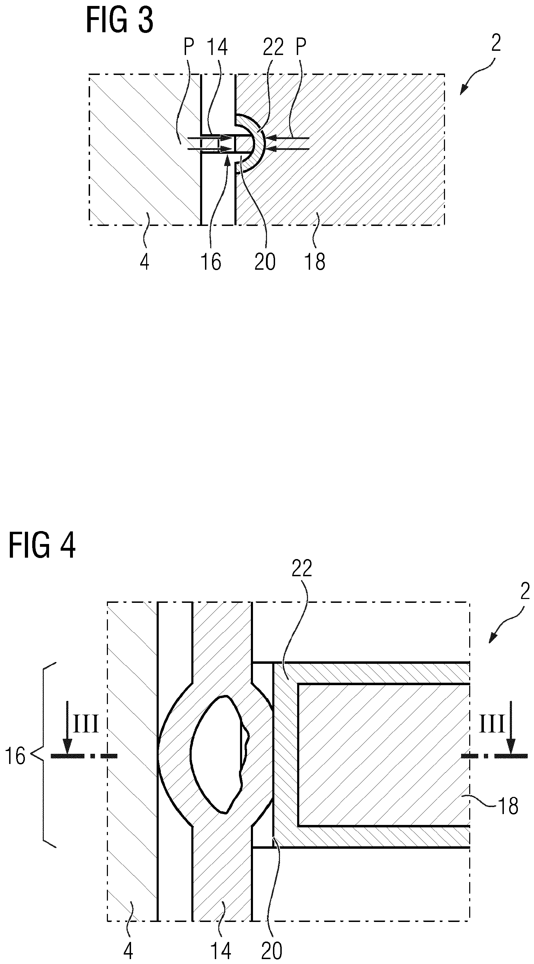

FIG 3 zeigt eine vergrößerte Längsschnittdarstellung der ersten Ausgestaltung eines Halbleitermoduls 2 im ersten Kontaktbereich 16. Der Pin 14 ist derartig in der metallisch beschichteten ersten Ausnehmung 20 angeordnet und kraftschlüssig mit dem ersten Substrat 18 verbunden, dass eine im Wesentlichen linienförmige Pressungsverteilung P ausgebildet ist. Optional berührt der Pin 14 das Gehäuse 4 zur Ausbildung der kraftschlüssigen Verbindung. Die weitere Ausführung des Halbleitermoduls 2 in FIG 3 entspricht der Ausführung in FIG 1.

FIG 4 zeigt eine vergrößerte Querschnittsdarstellung der ersten Ausgestaltung eines Halbleitermoduls 2 im ersten Kontaktbereich 16, wobei der Pin 14 einen Presspass-Anschluss aufweist, welcher bei der Ausbildung der kraftschlüssigen Verbindung mit dem ersten Substrat 18 elastisch und/oder plastisch verformt wird. Die weitere Ausführung des Halbleitermoduls 2 in FIG 4 entspricht der Ausführung in FIG 1.

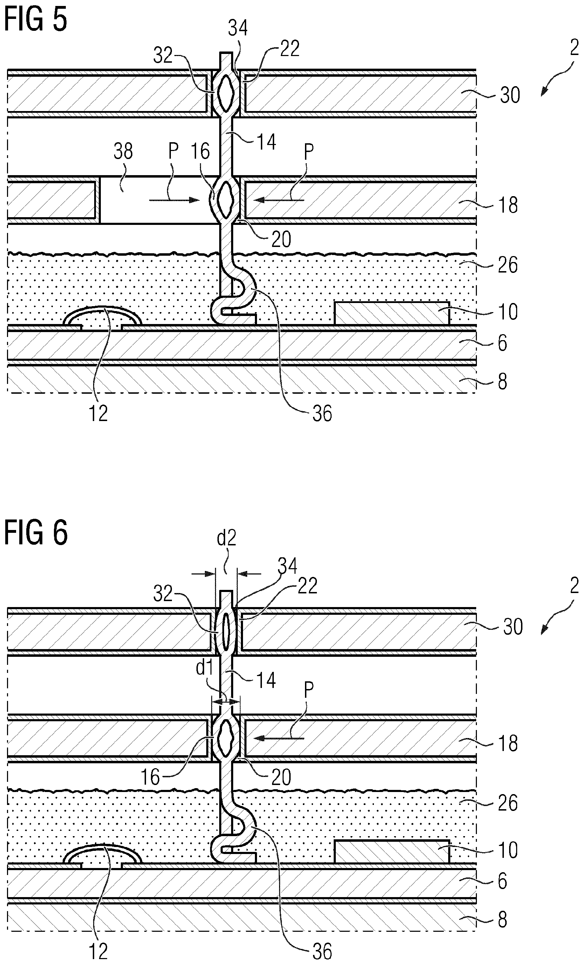

FIG 5 zeigt eine schematische Querschnittsdarstellung eines Ausschnitts einer dritten Ausgestaltung eines Halbleitermoduls 2, wobei der Pin 14 als freistehender Einpresskontakt mit einem ersten Kontaktbereich 16 und einem zweiten Kontaktbereich 32 ausgeführt ist und wobei der Pin 14 im zweiten Kontaktbereich 32 einen Presspass-Anschluss aufweist, welcher mit der zweiten Ausnehmung 34 des zweiten Substrats 30 kraftschlüssig verbunden ist. Der freistehende Pin 14 ist außerhalb des Gehäuses 4, welches das DCB-Keramiksubstrat 6 umschließt, angeordnet und frei auf dem DCB-Keramiksubstrat 6 positionierbar. Darüber hinaus weist der Pin 14 einen elastischen Abschnitt 36 auf und ist mit der der Bodenplatte 8 abgewandten Metallisierung des DCB-Keramiksubstrats 6 stoffschlüssig, insbesondere durch Löten oder Sintern, verbunden.

Das erste Substrat 18 weist eine, insbesondere rechteckförmige Aussparung 38 mit einer zumindest teilweise umlaufenden vertikalen Metallisierung 22 auf. Der Pin 14 weist im ersten Kontaktbereich 16 ein Übermaß mit einem elastisch und/oder plastisch nachgebenden Bereich auf, der exemplarisch als Presspass-Anschluss ausgeführt ist. Das erste Substrat 18 weist in der Aussparung 38 zumindest eine erste Ausnehmung 20 auf, in welcher die vertikale Metallisierung 22 ausgebildet und mit der Oberflächenmetallisierung elektrisch leitend verbunden ist. Über die Aussparung 38 ist beispielsweise das zweite Substrat 30 unmittelbar mit dem DCB-Keramiksubstrat 6 verbindbar. Der Pin 14 ist in der ersten Ausnehmung 20 teilweise aufgenommen und mit dieser kraftschlüssig verbunden, sodass das erste Substrat 18 über den Pin 14 elektrisch leitend mit dem Halbleiterbauelement 12 verbunden ist. Insbesondere umschließt die metallisch beschichtete erste Ausnehmung 20 den Pin 14 im ersten Kontaktbereich 16 maximal zur Hälfte, wobei die erste Ausnehmung 20 exemplarisch als Bohrungssegment ausgeführt ist. Alternativ ist die erste Ausnehmung 20 gefräst mit mindestens einer Ecke ausgeführt. Der Pin 14 ist derartig in der metallisch beschichteten ersten Ausnehmung 20 angeordnet und kraftschlüssig mit dem ersten Substrat 18 verbunden, dass eine im Wesentlichen linienförmige Pressungsverteilung P ausgebildet ist. Die weitere Ausführung des Halbleitermoduls 2 in FIG 5 entspricht der Ausführung in FIG 1.

FIG 6 zeigt eine schematische Querschnittsdarstellung eines Ausschnitts einer vierten Ausgestaltung eines Halbleitermoduls 2. Das erste Substrat 18 weist eine beidseitige zumindest teilweise strukturierte Metallisierung, insbesondere eine Oberflächenmetallisierung, sowie eine, insbesondere zylinderförmige, erste Ausnehmung 20 auf, welche den Pin 14 in einem ersten Kontaktbereich 16 vollständig umgibt. Der Pin 14 ist mit dem ersten Substrat 18 kraftschlüssig verbunden, wodurch der Pin 14 im ersten Kontaktbereich 16 elastisch und/oder plastisch verformt wird. Ein erster Durchmesser dl der ersten Ausnehmung 20 ist größer als ein zweiter Durchmesser d2 der zweiten Ausnehmung 34, sodass bei einer Fertigung des Halbleitermoduls 2 zuerst das erste Substrat 18 mit der größeren ersten Ausnehmung 20 über den zweiten Kontaktbereich 32 des Pins 14 bewegt und im Bereich des ersten Kontaktbereichs 16 kraftschlüssig verbunden wird. Daraufhin wird das zweite Substrat 30 mit der kleineren zweiten Ausnehmung 34 im zweiten Kontaktbereich 32 desselben Pins 14 verbunden. Die weitere Ausführung des Halbleitermoduls 2 in FIG 6 entspricht der Ausführung in FIG 5.

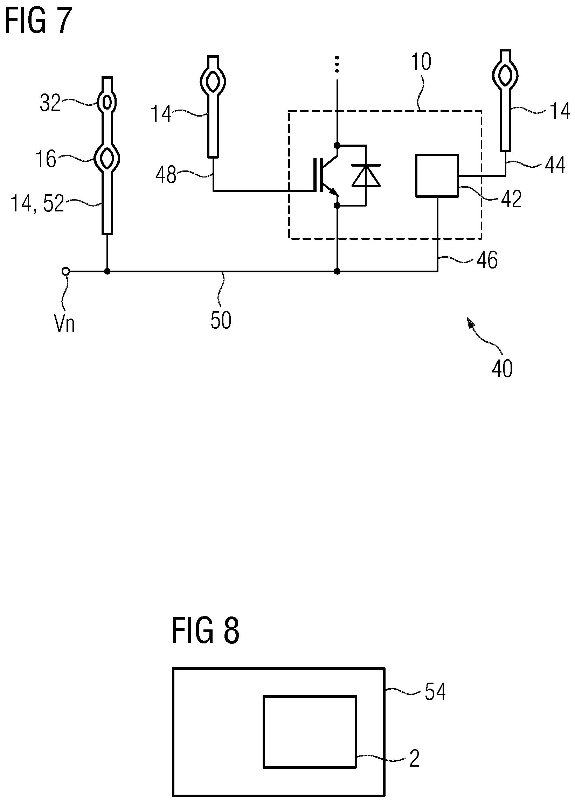

FIG 7 zeigt eine schematische Darstellung eines Teils einer Schaltung 40 des Halbleitermoduls 2, welche ein Halbleiterbauelement 10, das als IGBT ausgeführt ist, mit einem Sensor 42 aufweist. Alternativ ist der Sensor 42 außerhalb des Halbleiterbauelements 10 angeordnet und mit dem Halbleiterbauelement 10 verbunden. Beispielsweise ist der Sensor 42 als Temperatursensor ausgeführt, welcher thermisch mit dem Halbleiterbauelement 10 verbunden ist. Der Sensor weist einen ersten Sensoranschluss 44 und einen zweiten Sensoranschluss 46 auf. Das Halbleiterbauelement 10 weist einen ersten Treiberanschluss 48 und einen zweiten Treiberanschluss 50 auf, wobei der zweite Sensoranschluss 46 und der zweite Treiberanschluss 50 kurzgeschlossen und mit einer, insbesondere negativen, Versorgungsspannung Vn des Halbleiterbauelements 10 verbunden sind. Dem ersten Sensoranschluss 44 und dem ersten Treiberanschluss 48 ist jeweils ein Pin 14 zugewiesen, wobei beispielsweise der Pin 14 des ersten Treiberanschlusses 48 kürzer als der Pin 14 des ersten Sensoranschlusses 44 ausgestaltet ist, sodass der erste Treiberanschluss 48 mit dem ersten Substrat 18 und der erste Sensoranschluss 44 mit dem zweiten Substrat 30 verbindbar sind. Die kurzgeschlossenen Anschlüsse 46, 50 sind mit einem gemeinsamen Pin 52, welcher einen erster Kontaktbereich 16 zur Verbindung mit dem ersten Substrat 18 oder einen zweiten Kontaktbereich 32 zur Verbindung mit dem zweiten Substrat 30 aufweist, verbunden. Die Pins 14, 52 sind in FIG 7 symbolisch abstrahiert dargestellt, wobei der gemeinsame Pin 52, wie in den Figuren 1 bis 4 dargestellt, als ein in das Gehäuse 4 zumindest teilweise integrierter Pin 14 oder, wie in den Figuren 5 bis 6 dargestellt, als freistehender Pin 14 ausführbar ist.

FIG 8 zeigt eine schematische Darstellung eines Umrichters 54 mit einem Halbleitermodul 2. Je nach Architektur weist der Umrichter 54 zumindest ein weiteres Halbleitermodul 2 auf.

Zusammenfassend betrifft die Erfindung ein Halbleitermodul 2 mit einem Gehäuse 4, mindestens einem Halbleiterbauelement 10, einem ersten Substrat 18 und einem zweiten Substrat 30. Um ein Halbleitermodul 2 anzugeben, welches, im Vergleich zum Stand der Technik, kompakter ist, wird vorgeschlagen, dass zumindest das Halbleiterbauelement 10 und das erste Substrat 18 in dem Gehäuse 4 angeordnet sind, wobei das Halbleiterbauelement 10 elektrisch leitend mit mindestens einem Pin 14 verbunden ist, wobei der mindestens eine Pin 14 mit dem zweiten Substrat 18 kontaktiert und innerhalb des Gehäuses 4 unlösbar verbunden ist, wobei das erste Substrat 18 über den mindestens einen Pin 14 kraftschlüssig im Gehäuse 4 verbunden ist.

## Patentansprüche

1. Halbleitermodul (2) mit einem Gehäuse (4), mindestens einem Halbleiterbauelement (10), einem ersten Substrat (18) und einem zweiten Substrat (30),
wobei zumindest das Halbleiterbauelement (10) und das erste Substrat (18) in dem Gehäuse (4) angeordnet sind,
wobei das Halbleiterbauelement (10) elektrisch leitend mit mindestens einem Pin (14) verbunden ist,
wobei der mindestens eine Pin (14) mit dem zweiten Substrat (18) kontaktiert und innerhalb des Gehäuses (4) unlösbar verbunden ist,
**dadurch gekennzeichnet, dass**
das erste Substrat (18) über den mindestens einen Pin (14) kraftschlüssig im Gehäuse (4) verbunden ist.

2. Halbleitermodul (2) nach Anspruch 1,
wobei der Pin (14) in einem ersten Kontaktbereich (16) mit dem ersten Substrat (18) ein Übermaß mit einem elastisch und/oder plastisch nachgebenden Bereich zur Herstellung der kraftschlüssigen Verbindung aufweist.

3. Halbleitermodul (2) nach einem der Ansprüche 1 oder 2,
wobei das erste Substrat (18) eine erste Ausnehmung (20) aufweist, die den Pin (14) zumindest teilweise umschließt.

4. Halbleitermodul (2) nach einem der vorherigen Ansprüche,
wobei das erste Substrat (18) zumindest im Bereich der ersten Ausnehmung (20) eine metallische Beschichtung (22) aufweist, sodass das erste Substrat (18) elektrisch leitend mit dem Halbleiterbauelement (10) verbunden ist.

5. Halbleitermodul (2) nach Anspruch 4,
wobei die metallisch beschichtete erste Ausnehmung (20) als offene Ausnehmung ausgeführt ist, die den Pin (14) im ersten Kontaktbereich (16) teilweise, insbesondere maximal zur Hälfte, umschließt.

6. Halbleitermodul (2) nach einem der Ansprüche 4 oder 5,
wobei die metallisch beschichtete erste Ausnehmung (20) als Bohrungssegment ausgeführt ist.

7. Halbleitermodul (2) nach einem der Ansprüche 5 oder 6,
wobei der Pin (14) derartig in der metallisch beschichteten ersten Ausnehmung (20) angeordnet ist, dass eine im Wesentlichen linienförmige Pressungsverteilung (P) ausgebildet ist.

8. Halbleitermodul (2) nach einem der vorherigen Ansprüche,
wobei das zweite Substrat (30) eine metallisch beschichtete zweite Ausnehmung (34) aufweist, über welche der Pin (14) kraftschlüssig und/oder stoffschlüssig mit dem zweiten Substrat (30) elektrisch leitend verbunden ist.

9. Halbleitermodul (2) nach Anspruch 8,
wobei ein Durchmesser (d2) der zweiten Ausnehmung (34) kleiner als ein Durchmesser (dl) der ersten Ausnehmung (20) ist.

10. Halbleitermodul (2) nach einem der Ansprüche 8 oder 9,
wobei das zweite Substrat (30) über den mindestens einen Pin (14) elektrisch leitend mit dem Halbleiterbauelement (10) verbunden ist.

11. Halbleitermodul (2) nach einem der vorherigen Ansprüche,
wobei der Pin (14) als freistehender Pin ausgeführt ist und einen elastischen Abschnitt (36) aufweist.

12. Halbleitermodul (2) nach einem der Ansprüche 1 bis 10,
wobei der Pin (14) zumindest teilweise im Gehäuse (4) verlaufend angeordnet ist.

13. Halbleitermodul (2) nach einem der vorherigen Ansprüche, welches einen Sensor (42) umfasst, welcher zumindest einen Sensoranschluss (44, 46) aufweist,
wobei das Halbleiterbauelement (41) zumindest einen Treiberanschluss (48, 50) umfasst und
wobei zumindest ein Sensoranschluss (44, 46) und zumindest ein Treiberanschluss (48, 50) über einen gemeinsamen Pin (52) elektrisch leitend miteinander verbunden sind.

14. Umrichter (54) mit mindestens einem Halbleitermodul (2) nach einem der Ansprüche 1 bis 13.

15. Verfahren zu Herstellung eines Halbleitermoduls (2) nach einem der Ansprüche 1 bis 13,
wobei das erste Substrat (18) mit dem Pin (14) verbunden wird und daraufhin das zweite Substrat (30) mit demselben Pin (14) verbunden wird.
